# EUROPEAN PATENT APPLICATION

(11) **EP 1 691 238 A2**
(43) Date of publication of application: **16.08.2006**
(21) Application number: 06250564.9
(22) Date of filing: 02.02.2006
(51) Int. Cl.: G03F 7/09

(54) **Coating compositions for use with an overcoated photoresist**

(30) Priority: 05.02.2005 US 650340 P
(71) Applicant: Rohm and Haas Electronic Materials, L.L.C., Marlborough, Massachusetts 01752 (US)
(72) Inventor: Zampini, Anthony, Westborough Massachusetts 01581 (US); Pavelchek, Edward K., Massachusetts 02155 (US); Mori, James Michael, Medford Massachusetts 02155 (US)
(74) Representative: Kent, Venetia Katherine

(57) **Abstract**

In a first aspect, organic coating compositions are provided, particularly spin-on antireflective coating compositions, that contain a resin component with a blend of distinct resins, wherein at least one resin of the mixture comprises chromophore groups and at least one resin of the mixture is at least substantially or completely free of chromophore groups. In a further aspect, systems are provided that include use of multiple underlying organic antireflective coating compositions that have differing absorbances of radiation used to image an overcoated photoresist composition layer.

## Description

### BACKGROUND OF THE INVENTION

### 1. Field of the Invention

The present invention relates to compositions (particularly antireflective coating compositions or "ARCs") that can reduce reflection of exposing radiation from a substrate back into an overcoated photoresist layer and/or function as a planarizing or via-fill layer. More particularly, in a first aspect, the invention relates to organic coating compositions, particularly antireflective coating compositions, that contain a resin component with a mixture of distinct resins, wherein at least one blend member comprises chromophore groups and at least one blend member is at least substantially or completely free of chromophore groups. In a further aspect, the invention relates to use of multiple underlying antireflective coating compositions that have differing absorbances to radiation used to image an overcoated photoresist layer.

### 2. Background

Photoresists are photosensitive films used for the transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced or chemical transformation of the photoresist coating to thereby transfer the pattern of the photomask to the photoresist-coated substrate. Following exposure, the photoresist is developed to provide a relief image that permits selective processing of a substrate.

A photoresist can be either positive-acting or negative-acting. For most negative-acting photoresists, those coating layer portions that are exposed to activating radiation polymerize or crosslink in a reaction between a photoactive compound and polymerizable reagents of the photoresist composition. Consequently, the exposed coating portions are rendered less soluble in a developer solution than unexposed portions. For a positive-acting photoresist, exposed portions are rendered more soluble in a developer solution while areas not exposed remain comparatively less soluble in the developer solution. Photoresist compositions are described in Deforest, *Photoresist Materials and Processes,* McGraw Hill Book Company, New York, ch. 2, 1975 and by Moreau, *Semiconductor Lithography, Principles, Practices and Materials,* Plenum Press, New York, ch. 2 and 4.

A major use of photoresists is in semiconductor manufacture where an object is to convert a highly polished semiconductor slice, such as silicon or gallium arsenide, into a complex matrix of electron conducting paths, preferably of micron or submicron geometry, that perform circuit functions. Proper photoresist processing is a key to attaining this object. While there is a strong interdependency among the various photoresist processing steps, exposure is believed to be one of the most important steps in attaining high resolution photoresist images.

Reflection of activating radiation used to expose a photoresist often poses limits on resolution of the image patterned in the photoresist layer. Reflection of radiation from the substrate/photoresist interface can produce spatial variations in the radiation intensity in the photoresist, resulting in non-uniform photoresist linewidth upon development. Radiation also can scatter from the substrate/photoresist interface into regions of the photoresist where exposure is non intended, again resulting in linewidth variations. The amount of scattering and reflection will typically vary from region to region, resulting in further linewidth non-uniformity. Variations in substrate topography also can give rise to resolution-limiting problems.

One approach used to reduce the problem of reflected radiation has been the use of a radiation absorbing layer interposed between the substrate surface and the photoresist coating layer. See for example, PCT Application WO 90/03598, EPO Application No. 0 639 941 A1 and U.S. Patents 4,910,122, 4370,405, 4,362,809, and 5,939,236. Such layers have also been referred to as antireflective layers or antireflective compositions. See also U.S. Patents 5,939,236; 5,886,102; 5,851,738; 5,851,730; 5,939,236; 6,165,697; 6,316,165; 6,451,503; 6,472,128; 6,502,689; 6,503,689; 6,528,235; 6,653,049; and U.S. Published Patent Applications 20030180559 and 2003008237, all assigned to the Shipley Company, which disclose highly useful antireflective compositions.

For many high performance lithographic applications, particular antireflective compositions are utilized in order to provide the desired performance properties, such as optimal absorption properties and coating characteristics. See, for instance, the above-mentioned patent documents. Nevertheless, electronic device manufacturers continually seek increased resolution of a photoresist image patterned over antireflective coating layers and in turn demand ever-increasing performance from an antireflective composition.

It thus would be desirable to have new antireflective compositions for use with an overcoated photoresist. It would be particularly desirable to have new antireflective compositions that exhibit enhanced performance and could provide increased resolution of an image patterned into an overcoated photoresist.

### SUMMARY OF THE INVENTION

We have found that at least certain imaging environments can pose challenging and difficult reflection issues which can compromise resolution of a developed photoresist image. In particular, exceptionally dark substrates such as nitride or carbon layers can make difficult effective imaging of a resist layer, especially bottom portions thereof. Immersion lithography also can present challenges due to more severe angles of incident exposure radiation.

We have now discovered new antireflective compositions ("ARCs") for use with an overcoated photoresist layer. Preferred organic coating compositions and systems of the invention can provide enhanced lithographic results (resolution) of an overcoated photoresist image, including in challenging imaging environments, such as imaging over dark substrates and immersion lithography systems.

More specifically, in a first aspect, organic coating compositions, particularly antireflective compositions for use with an overcoated photoresist, are provided that comprise a resin component that contains a mixture of distinct resins, wherein at least one resin of the mixture comprises chromophore groups and at least one resin of the mixture is at least substantially or completely free of chromophore groups.

For coating compositions utilized with an overcoated photoresist composition that is imaged at 248 nm, particularly preferred underlying coating compositions comprise at least one resin that comprises optionally substituted anthracene or naphthyl and at least one distinct resin that will be at least substantially or completely free of such anthracene or naphthyl groups and may be at least substantially or completely free of any aromatic groups.

For coating compositions utilized with an overcoated photoresist composition that is imaged at 193 nm, particularly preferred underlying coating compositions comprise at least one resin that comprises optionally substituted phenyl and at least one distinct resin that will be at least substantially or completely free of such phenyl groups and may be at least substantially or completely free of any aromatic groups.

Such coating compositions can be tailored to provide a desired level of absorbance by utilizing selected amounts of one or more resins that comprise chromophore groups and one or more resins that are at least substantially free or completely free of aromatic groups. A particular resin combination can be formulated and absorbance thereof tested to determine optimal resin blending ratios.

In a further aspect of the invention, resist systems are provided that include multiple underlying organic coating compositions, particularly antireflective coating compositions, where at least two of the organic coating composition have differing absorbances of the radiation that is used to image an overcoated photoresist composition layer. Preferably, two underlying organic coating compositions are employed that that have differing absorbances to the radiation that is used to image an overcoated photoresist layer, particularly different k values (where k is imaginary refractive index value, which can be determined empirically by an ellipsometer, as discussed below). In this aspect of the invention, particularly preferred is where the multiple underlying organic coating compositions do not contain a silicon-containing resin (such as a silsesquioxane). It is generally preferred that the bottom coating layer (first applied) has a greater absorbance than the next applied coating layer. It may be suitable that the k values of the two applied coating layers differ by at least about 0.1, 0.2, 0.3, 0.4 or 0.5 (as measured at 193 nm or 248 nm). In particular suitable systems, as measured at 193 nm, a first applied coating layer may have a k value of about 0.4 to about 0.7, preferably about 0.45 to 0.55, and the next applied (overcoated) layer may have a k value of about 0.1 to about 0.4, more preferably about 0.15 to about 0.3. Protocols for determining k values as specified herein are detailed below.

In both aspects of the invention, coating compositions of the invention preferably are crosslinking compositions and contain a material that will crosslink or otherwise cure upon e.g. thermal or activating radiation treatment. Typically, the composition will contain a crosslinker component, e.g. an amine-containing material such as a melamine or benzoguanamine compound or resin.

Preferably, crosslinking compositions of the invention can be cured through thermal treatment of the composition coating layer. Suitably, the coating composition also contains an acid or more preferably an acid generator compound, particularly a thermal acid generator compound, to facilitate the crosslinking reaction.

For use as an antireflective coating composition, as well as other applications such as via-fill, preferably the composition is crosslinked prior to applying a photoresist composition layer over the composition layer.

As indicated above, antireflective compositions of the invention also preferably contain a component that comprises chromophore groups that can absorb undesired radiation used to expose the overcoated resist layer from reflecting back into the resist layer. Such chromophore groups may be present with other composition components such as the resin(s) or an acid generator compound, or the composition may comprise another component that may comprise such chromophore units, e.g. a small molecule (e.g. MW less than about 1000 or 500) that contains one or more chromophore moieties, such as one or more optionally substituted phenyl, optionally substituted anthracene or optionally substituted naphthyl groups.

Generally preferred chromophores for inclusion in coating composition of the invention particularly those used for antireflective applications include both single ring and multiple ring aromatic groups such as optionally substituted phenyl, optionally substituted naphthyl, optionally substituted anthracenyl, optionally substituted phenanthracenyl, optionally substituted quinolinyl, and the like. Particularly preferred chromophores may vary with the radiation employed to expose an overcoated resist layer. More specifically, for exposure of an overcoated resist at 248 nm, optionally substituted anthracene and optionally substituted naphthyl are preferred chromophores of the antireflective composition. For exposure of an overcoated resist at 193 nm, optionally substituted phenyl and optionally substituted naphthyl are particularly preferred chromophores of the antireflective composition. Preferably, such chromophore groups are linked (e.g. pendant groups) to a resin component of the antireflective composition.

Coating compositions of the invention are typically formulated and applied to a substrate as an organic solvent solution, suitably by spin-coating (i.e. a spin-on composition).

A variety of photoresists may be used in combination (i.e. overcoated) with a coating composition of the invention. Preferred photoresists for use with the antireflective compositions of the invention are chemically-amplified resists, especially positive-acting photoresists that contain one or more photoacid generator compounds and a resin component that contains units that undergo a deblocking or cleavage reaction in the presence of photogenerated acid, such as photoacid-labile ester, acetal, ketal or ether units. Negative-acting photoresists also can be employed with coating compositions of the invention, such as resists that crosslink (i.e. cure or harden) upon exposure to activating radiation. Preferred photoresists for use with a coating composition of the invention may be imaged with relatively short-wavelength radiation, e.g. radiation having a wavelength of less than 300 nm or less than 260 nm such as about 248 nm, or radiation having a wavelength of less than about 200 nm, such as 193 nm.

The invention further provides methods for forming a photoresist relief image and novel articles of manufacture comprising substrates (such as a microelectronic wafer substrate) coated with an antireflective composition of the invention alone or in combination with a photoresist composition.

As discussed above, in one aspect of the invention, multiple organic coating compositions are employed that have differing absorbances of exposure radiation, particularly differing imaginary (k) refractive index values. As referred to herein, absorbance values, particularly imaginary (k) refractive index values, of underlying organic coating compositions are determined as follows: a coating layer of the organic composition is obtained on 200mm silicon wafers using a spin coating tool. Spin-speeds can be varied as necessary to obtain film thickness in the range of 40-120nm. Solvent is removed and the applied coating layer is cured at 215°C for 60 seconds on a proximity hotplate. An ellipsometer (such as a WVASE32 ellipsometer (which is a Wollman VASE ellipsometer)) is used to determine film thicknesses and real (n) and imaginary (k) refractive indices.

Other aspects of the invention are disclosed infra.

### BRIEF DESCRIPTION OF THE DRAWINGS

FIG. 1 shows a SEM of a developed photoresist relief image over an antireflective composition of Example 30 which follows.
FIG. 2 shows a SEM of a developed photoresist relief image over an antireflective composition of Example 33 which follows.
FIG. 3 shows a SEM of a developed photoresist relief image over multiple antireflective composition layers (trilayer system).

### DETAILED DESCRIPTION OF THE INVENTION

We now provide new organic coating compositions that are particularly useful with an overcoated photoresist layer. Preferred coating compositions of the invention may be applied by spin-coating (spin-on compositions) and formulated as a solvent composition. The coating compositions of the invention are especially useful as antireflective compositions for an overcoated photoresist and/or as planarizing or via-fill compositions for an overcoated photoresist composition coating layer.

### Underlying coating compositions:

As discussed above, in one aspect of the invention, underlying coating compositions are formulated with a plurality of distinct resins. Preferably, the types and amounts of resins used in a coating composition are selected to attain a desired target real index n and a desired imaginary index k.

In certain at least certain preferred systems, the types and amounts of resins used in a coating composition are selected to attain a desired target real index n from between about 1.5 (particularly 1.50) to about 2.1 (particularly 2.10) and a desired imaginary index k from about 0.15 (particularly 0.20) to 0.7 (particularly 0.70).

As is known, the refractive index of an underlying coating composition as disclosed herein at the exposure wavelength is the complex number N=nik, where n is the real part ofN, and is equivalent to what is commonly called the "refractive index", k is the imaginary part of N and is related to the absorption coefficient of the exposure wavelength. Such values n and k of a particular coating composition can be readily determined using a commercially available ellipsometer, as discussed above as well as in the examples which follow.

As discussed above, in the first aspect of the invention, that contain a resin component with a mixture of distinct resins, wherein at least one resin of the mixture comprises groups that are chromphores for radiation used to image an overcoated photoresist layer chromophore groups and at least one resin of the mixture is at least substantially or completely free of such chromophore groups.

Those chromophore groups typically are aromatic groups and in general are carbocyclic aryl groups such as phenyl (particularly for an overcoated photoresist imaged at 193 nm), naphthyl (particularly for an overcoated photoresist imaged at 193 nm or 248 nm), or anthracene (particularly for an overcoated photoresist imaged at 248 nm).

References herein to a resin that is "at least substantially free of chromophore groups" for the exposure radiation of an overcoated photoresist or other similar phrase indicate that less than about 10 molar percent of the total resin repeat units contain the chromophore groups that are present in the other resin(s) of the underlying coating composition, and more typically less than about 8, 7, 6, 5, 4, 3, 2, 1 or 0.5 mole percent of the total repeat units of the comparatively transparent resin will contain chromophore groups that are present on the other resin(s) of the underlying coating composition. Often, such "transparent" resins (i.e. the resins that are at least substantially free of chromophore groups) will have a similar absence of aromatic groups, e.g. less than about 10, 8, 7, 6, 5, 4, 3, 2, 1 or 0.5 mole percent of the total repeat units of the resin will contain any aromatic groups.

The different resins of a resin component suitably may have distinct or the same or similar resin backbone structures. For example, suitable resin mixture members include polyesters, polyacrylates, polysulfones, polyamides, poly(vinylalcohols), and the like. Particularly preferred are resin components that comprise one or more polyester resins and/or one or more poly(acrylate) resins.

More specifically, preferred resins employed in underlying coating compositions of the invention include resins that contain ester repeat units (polyester), such as provided by polymerization of a carboxy-containing compound (such as a carboxylic acid, ester, anhydride, etc.) and a hydroxy-containing compound, preferably a compound having multiple hydroxy groups such as a glycol, e.g. ethylene glycol or propylene glycol, or glycerol, or other diols, triols, tetraols and the like.

Preferably, an ester functionality is present as a component of, or within, the polymer backbone rather than as a pendant or side chain unit. Ester moieties also may be present as a pendant group, but preferably the polymer also contains an ester functionality along the polymer backbone. Also preferred is where the ester repeat unit comprises aromatic substitution, such as optionally substituted carbocyclic aryl groups e.g. optionally substituted phenyl, naphthyl or anthracenyl substitution, either as a side chain or more preferably along the polymer backbone.

It will be understood that in such polyester resins at least certain of the ester groups are not photoacid-labile, i.e. the ester repeat units do not undergo deblocking or other cleavage during typical lithographic processing of pre-exposure bake, exposure to activating radiation, post-exposure heating, and/or development. Preferably, ester repeat units are present in the polymer backbone, i.e. the ester groups (-(C=O)O-) are present on the branched or substantially linear chain that forms the polymer length. Also preferred is that such ester groups contain aromatic substitution, e.g. a phenyl, naphthyl or anthracene group, such as may be provided by reaction of a an alkyl phthalate with a polyol.

Such a polyester resin may contain other repeat units, either as pendant or side chain units, or as other repeat units along the polymer backbone. For example, the resin may be a copolymer (e.g. two distinct repeat units along resin backbone), terpolymer (e.g. three distinct repeat units along resin backbone), tetraplymer (e.g. four distinct repeat units along polymer backbone) or pentapolymer (e.g. five distinct repeat units along polymer backbone). For instance, suitable will be polymers that contain ether and ester repeat units, or alkylene repeat units together with ester and ether units. Additional repeat units that contain one or more oxygen atoms are preferred for many applications.

Exemplary preferred resins that may be utilized in coating compositions of the invention include those that are formed by reaction of a compound that contains one or more carboxyl (e.g. ester, anhydride, carbocyclic acid) groups together with a compound that contains one or more hydroxy group preferably at least two hydroxy groups. The carboxyl-containing compound also preferably may contain two or more carboxyl (-C=OO-) groups. The carboxyl and hydroxy compound are suitably reacted in the presence of acid, optionally with other compounds if copolymer or other higher order polymer is desired, to thereby provide a polyester resin.

Such polyester resins are suitably prepared by charging a reaction vessel with the a polyol, a carboxylate compound, and other compounds to be incorporated into the formed resin, an acid such as a sulfonic acid, e.g. methane sulfonic acid or para-toluene sulfonic acid, and the like. The reaction mixture is suitably stirred at an elevated temperature, e.g. at least about 80°C, more typically at least about 100°C, 110°C, 120°C, 130°C, 140°C, or 150°C for a time sufficient for polymer formation, e.g. at least about 2, 3, 4, 5, 6, 8, 12, 16, 20, 24 hours. Exemplary preferred conditions for synthesis of useful resins are detailed in the examples which follow.

Acrylate-based resins also are preferred materials to use in underlying coating compositions of the invention. Such resins can be prepared by known methods, such as polymerization (e.g. in the presence of a radical initiator) of one or more acrylate monomers such as e.g. hydroxyethylmethylacrylate, hydroxyethylacrylate, methylmethacrylate, butyl methacrylatemethylanthracene methacrylate or other anthracene acrylate and the like. See U.S. Patent 5,886,102 assigned to the Shipley Company for exemplary suitable polymers. See also the examples which follow for suitable acrylate resins and syntheses thereof.

For antireflective applications, suitably one or more of the compounds reacted to form the resin comprise a moiety that can function as a chromophore to absorb radiation employed to expose an overcoated photoresist coating layer. For example, a phthalate compound (e.g. a phthalic acid or dialkyl phthalate (i.e. di-ester such as each ester having 1-6 carbon atoms, preferably a di-methyl or ethyl phthalate) may be polymerized with an aromatic or non-aromatic polyol and optionally other reactive compounds to provide a polyester particularly useful in an antireflective composition employed with a photoresist imaged at sub-200 nm wavelengths such as 193 nm. Similarly, resins to be used in compositions with an overcoated photoresist imaged at sub-300 nm wavelengths or sub-200 nm wavelengths such as 248 nm or 193 nm, a naphthyl compound may be polymerized, such as a naphthyl compound containing one or two or more carboxyl substituents e.g. dialkyl particularly di-C₁₋₆alkyl naphthalenedicarboxylate. Reactive anthracene compounds also are preferred, e.g. an anthracene compound having one or more carboxy or ester groups, such as one or more methyl ester or ethyl ester groups.

The compound that contains a chromophore unit also may contain one or preferably two or more hydroxy groups and be reacted with a carboxyl-containing compound. For example, a phenyl compound or anthracene compound having one, two or more hydroxyl groups may be reacted with a carboxyl-containing compound.

Additionally, antireflective compositions may contain a material that contains chromophore units that is separate from the polyester resin component. For instance, the coating composition may comprise a polymeric or non-polymeric compound that contain phenyl, anthracene, naphthyl, etc. units. It is often preferred, however, that the ester-resin contain chromophore moieties.

As mentioned, preferred antireflective coating compositions of the invention can be crosslinked, e.g. by thermal and/or radiation treatment. For example, preferred antireflective coating compositions of the invention may contain a separate crosslinker component that can crosslink with one ore more other components of the antireflective composition. Generally preferred crosslinking antireflective compositions comprise a separate crosslinker component. Particularly preferred antireflective compositions of the invention contain as separate components: a resin, a crosslinker, and a thermal acid generator compound. Additionally, crosslinking antireflective compositions of the invention preferably can also contain an amine basic additive to promote elimination of footing or notching of the overcoated photoresist layer. Crosslinking antireflective compositions are preferably crosslinked prior to application of a photoresist layer over the antireflective coating layer. Thermal-induced crosslinking of the antireflective composition by activation of the thermal acid generator is generally preferred.

Crosslinking antireflective compositions of the invention preferably comprise an ionic or substantially neutral thermal acid generator, e.g. an ammonium arenesulfonate salt, for catalyzing or promoting crosslinking during curing of an antireflective composition coating layer. Typically one or more thermal acid generators are present in an antireflective composition in a concentration from about 0.1 to 10 percent by weight of the total of the dry components of the composition (all components except solvent carrier), more preferably about 2 percent by weight of the total dry components.

As discussed above, antireflective compositions may suitably contain additional resin component. Suitable resin components may contain chromophore units for absorbing radiation used to image an overcoated resist layer before undesired reflections can occur.

For deep UV applications (i.e. the overcoated resist is imaged with deep UV radiation), a polymer of an antireflective composition preferably will absorb reflections in the deep UV range (typically from about 100 to 300 nm). Thus, the polymer preferably contains units that are deep UV chromophores, i.e. units that absorb deep UV radiation. Highly conjugated moieties are generally suitable chromophores. Aromatic groups, particularly polycyclic hydrocarbon or heterocyclic units, are typically preferred deep UV chromophore, e.g. groups having from two to three to four fused or separate rings with 3 to 8 members in each ring and zero to three N, O or S atoms per ring. Such chromophores include optionally substituted phenanthryl, optionally substituted anthracyl, optionally substituted acridine, optionally substituted naphthyl, optionally substituted quinolinyl and ring-substituted quinolinyls such as hydroxyquinolinyl groups. Optionally substituted anthracenyl groups are particularly preferred for 248 nm imaging of an overcoated resist. Preferred antireflective composition resins have pendant anthracene groups. Preferred resins include those of Formula I as disclosed on page 4 of European Published Application 813114A2 of the Shipley Company.

Another preferred resin binder comprises optionally substituted quinolinyl groups or a quinolinyl derivative that has one or more N, O or S ring atoms such as a hydroxyquinolinyl. The polymer may contain other units such as carboxy and/or alkyl ester units pendant from the polymer backbone. A particularly preferred antireflective composition resin in an acrylic containing such units, such as resins of formula II disclosed on pages 4-5 of European Published Application 813114A2 of the Shipley Company.

As discussed above, for imaging at 193 nm, the antireflective composition preferably may contain a resin that has phenyl chromophore units. For instance, one suitable antireflective resin for use with photoresists imaged at 193 nm is a terpolymer consisting of polymerized units of styrene, 2-hydroxyethylmethacrylate and methylmethacrylate (30:38:32 mole ratio). Such phenyl group containing resins and use of same in antireflective compositions have been disclosed in U.S. application serial number 09/153,575, file 1998 and corresponding European Published Application EP87600A1, assigned to the Shipley Company.

Such coating compositions comprising a resin or other component are employed as described above. Thus, for example, the composition may suitably comprise a crosslinker and an acid source such as an acid or acid generator compound particularly a thermal acid generator compound whereby the applied coating composition can be crosslinked such as by thermal treatment prior to application of an overcoated photoresist layer.

Preferably resins of antireflective compositions of the invention will have a weight average molecular weight (Mw) of about 1,000 to about 10,000,000 daltons, more typically about 5,000 to about 1,000,000 daltons, and a number average molecular weight (Mn) of about 500 to about 1,000,000 daltons. Molecular weights (either Mw or Mn) of the polymers of the invention are suitably determined by gel permeation chromatography.

While coating composition resins having absorbing chromophores are generally preferred, antireflective compositions of the invention may comprise other resins either as a co-resin or as the sole resin binder component. For example, phenolics, e.g. poly(vinylphenols) and novolaks, may be employed. Such resins are disclosed in the incorporated European Application EP 542008 of the Shipley Company. Other resins described below as photoresist resin binders also could be employed in resin binder components of antireflective compositions of the invention.

The concentration of such a resin component of the coating compositions of the invention may vary within relatively broad ranges, and in general the resin binder is employed in a concentration of from about 50 to 95 weight percent of the total of the dry components of the coating composition, more typically from about 60 to 90 weight percent of the total dry components (all components except solvent carrier).

In the first aspect of the invention, which includes use of a first resin that comprises chromophore groups and a second resin that is at least substantially free of chromophore groups, the relative amounts of those first and second distinct resins may suitably vary, including with the desired absorbance that is being targeted as discussed above. For example, such first and second resins may be suitably present in relative weight ration of 10 to 90 to 90 to 10, more typically about 20 to 70 to about 70 to 30.

As discussed above, crosslinking-type coating compositions of the invention also contain a crosslinker component. A variety of crosslinkers may be employed, including those antireflective composition crosslinkers disclosed in Shipley European Application 542008 incorporated herein by reference. For example, suitable antireflective composition crosslinkers include amine-based crosslinkers such as melamine materials, including melamine resins such as manufactured by Cytec Industries and sold under the tradename of Cymel 300, 301, 303, 350, 370, 380, 1116 and 1130. Glycolurils are particularly preferred including glycolurils available from Cytec Industries. Benzoquanamines and urea-based materials also will be suitable including resins such as the benzoquanamine resins available from Cytec Industries under the name Cymel 1123 and 1125, and urea resins available from Cytec Industries under the names of Powderlink . 1174 and 1196. In addition to being commercially available, such amine-based resins may be prepared e.g. by the reaction of acrylamide or methacrylamide copolymers with formaldehyde in an alcohol-containing solution, or alternatively by the copolymerization ofN-alkoxymethyl acrylamide or methacrylamide with other suitable monomers.

Suitable substantially neutral crosslinkers include hydroxy compounds, particularly polyfunctional compounds such as phenyl or other aromatics having one or more hydroxy or hydroxy alkyl substitutents such as a C₁₋₈hydroxyalkyl substitutents. Phenol compounds are generally preferred such as di-methanolphenol (C₆H₃(CH₂OH)₂)OH) and other compounds having adjacent (within 1-2 ring atoms) hydroxy and hydroxyalkyl substitution, particularly phenyl or other aromatic compounds having one or more methanol or other hydroxylalkyl ring substituent and at least one hydroxy adjacent such hydroxyalkyl substituent.

It has been found that a substantially neutral crosslinker such as a methoxy methylated glycoluril used in antireflective compositions of the invention can provide excellent lithographic performance properties.

A crosslinker component of antireflective compositions of the invention in general is present in an amount of between about 5 and 50 weight percent of total solids (all components except solvent carrier) of the antireflective composition, more typically in an amount of about 7 to 25 weight percent total solids.

Coating compositions of the invention, particularly for reflection control applications, also may contain additional dye compounds that absorb radiation used to expose an overcoated photoresist layer. Other optional additives include surface leveling agents, for example, the leveling agent available under the tradename Silwet 7604 from Union Carbide, or the surfactant FC 171 or FC 431 available from the 3M Company.

Coating compositions of the invention also may contain one or more photoacid generator compound typically in addition to another acid source such as an acid or thermal acid generator compound. In such use of a photoacid generator compound (PAG), the photoacid generator is not used as an acid source for promoting a crosslinking reaction, and thus preferably the photoacid generator is not substantially activated during crosslinking of the coating composition (in the case of a crosslinking coating composition). Such use of photoacid generators is disclosed in U.S. Patent 6,261,743 assigned to the Shipley Company. In particular, with respect to coating compositions that are thermally crosslinked, the coating composition PAG should be substantially stable to the conditions of the crosslinking reaction so that the PAG can be activated and generate acid during subsequent exposure of an overcoated resist layer. Specifically, preferred PAGs do not substantially decompose or otherwise degrade upon exposure of temperatures of from about 140 or 150 to 190°C for 5 to 30 or more minutes.

Generally preferred photoacid generators for such use in antireflective compositions or other coating of the invention include e.g. onium salts such as di(4-tert-butylphenyl)iodonium perfluoroctane sulphonate, halogenated non-ionic photoacid generators such as 1,1-bis[p-chlorophenyl]-2,2,2-trichloroethane, and other photoacid generators disclosed for use in photoresist compositions. For at least some antireflective compositions of the invention, antireflective composition photoacid generators will be preferred that can act as surfactants and congregate near the upper portion of the antireflective composition layer proximate to the antireflective composition/resist coating layers interface. Thus, for example, such preferred PAGs may include extended aliphatic groups, e.g. substituted or unsubstituted alkyl or alicyclic groups having 4 or more carbons, preferably 6 to 15 or more carbons, or fluorinated groups such as C₁₋₁₅alkyl or C₂₋₁₅alkenyl having one or preferably two or more fluoro substituents.

To make a liquid coating composition of the invention, the components of the coating composition are dissolved in a suitable solvent such as, for example, one or more oxyisobutyric acid esters particularly methyl-2-hydroxyisobutyrate as discussed above, ethyl lactate or one or more of the glycol ethers such as 2-methoxyethyl ether (diglyme), ethylene glycol monomethyl ether, and propylene glycol monomethyl ether; solvents that have both ether and hydroxy moieties such as methoxy butanol, ethoxy butanol, methoxy propanol, and ethoxy propanol; esters such as methyl cellosolve acetate, ethyl cellosolve acetate, propylene glycol monomethyl ether acetate, dipropylene glycol monomethyl ether acetate and other solvents such as dibasic esters, propylene carbonate and gamma-butyro lactone. A preferred solvent for an antireflective coating composition of the invention is methyl-2-hydroxyisobutyrate, optionally blended with anisole. The concentration of the dry components in the solvent will depend on several factors such as the method of application. In general, the solids content of an antireflective composition varies from about 0.5 to 20 weight percent of the total weight of the coating composition, preferably the solids content varies from about 2 to 10 weight of the coating composition.

### Exemplary photoresist systems

A variety of photoresist compositions can be employed with coating compositions of the invention, including positive-acting and negative-acting photoacid-generating compositions. Photoresists used with antireflective compositions of the invention typically comprise a resin binder and a photoactive component, typically a photoacid generator compound. Preferably the photoresist resin binder has functional groups that impart alkaline aqueous developability to the imaged resist composition.

As discussed above, particularly preferred photoresists for use with antireflective compositions of the invention are chemically-amplified resists, particularly positive-acting chemically-amplified resist compositions, where the photoactivated acid in the resist layer induces a deprotection-type reaction of one or more composition components to thereby provide solubility differentials between exposed and unexposed regions of the resist coating layer. A number of chemically-amplified resist compositions have been described, e.g., in U.S. Pat. Nos. 4,968,581; 4,883,740; 4,810,613; 4,491,628 and 5,492,793, al of which are incorporated herein by reference for their teaching of making and using chemically amplified positive-acting resists. Coating compositions of the invention are particularly suitably used with positive chemically-amplified photoresists that have acetal groups that undergo deblocking in the presence of a photoacid. Such acetal-based resists have been described in e.g. U.S. Patents 5,929,176 and 6,090,526.

The antireflective compositions of the invention also may be used with other positive resists, including those that contain resin binders that comprise polar functional groups such as hydroxyl or carboxylate and the resin binder is used in a resist composition in an amount sufficient to render the resist developable with an aqueous alkaline solution. Generally preferred resist resin binders are phenolic resins including phenol aldehyde condensates known in the art as novolak resins, homo and copolymers or alkenyl phenols and homo and copolymers of N-hydroxyphenyl-maleimides.

Preferred positive-acting photoresists for use with an underlying coating composition of the invention contains an imaging-effective amount of photoacid generator compounds and one or more resins that are selected from the group of:
1) a phenolic resin that contains acid-labile groups that can provide a chemically amplified positive resist particularly suitable for imaging at 248 nm. Particularly preferred resins of this class include: i) polymers that contain polymerized units of a vinyl phenol and an alkyl acrylate, where the polymerized alkyl acrylate units can undergo a deblocking reaction in the presence of photoacid. Exemplary alkyl acrylates that can undergo a photoacid-induced deblocking reaction include e.g. t-butyl acrylate, t-butyl methacrylate, methyladamantyl acrylate, methyl adamantyl methacrylate, and other non-cyclic alkyl and alicyclic acrylates that can undergo a photoacid-induced reaction, such as polymers in U.S. Patents 6,042,997 and 5,492,793, incorporated herein by reference; ii) polymers that contain polymerized units of a vinyl phenol, an optionally substituted vinyl phenyl (e.g. styrene) that does not contain a hydroxy or carboxy ring substituent, and an alkyl acrylate such as those deblocking groups described with polymers i) above, such as polymers described in U.S. Patent 6,042,997, incorporated herein by reference; and iii) polymers that contain repeat units that comprise an acetal or ketal moiety that will react with photoacid, and optionally aromatic repeat units such as phenyl or phenolic groups; such polymers have been described in U.S. Patents 5,929,176 and 6,090,526, incorporated herein by reference.
2) a resin that is substantially or completely free of phenyl or other aromatic groups that can provide a chemically amplified positive resist particularly suitable for imaging at sub-200 nm wavelengths such as 193 nm. Particularly preferred resins of this class include: i) polymers that contain polymerized units of a non-aromatic cyclic olefin (endocyclic double bond) such as an optionally substituted norbornene, such as polymers described in U.S. Patents 5,843,624, and 6,048,664, incorporated herein by reference; ii) polymers that contain alkyl acrylate units such as e.g. t-butyl acrylate, t-butyl methacrylate, methyladamantyl acrylate, methyl adamantyl methacrylate, and other non-cyclic alkyl and alicyclic acrylates; such polymers have been described in U.S. Patent 6,057,083; European Published Applications EP01008913A1 and EP00930542A1; and U.S. pending Patent Application No. 09/143,462, all incorporated herein by reference, and iii) polymers that contain polymerized anhydride units, particularly polymerized maleic anhydride and/or itaconic anhydride units, such as disclosed in European Published Application EP01008913A1 and U.S. Patent 6,048,662, both incorporated herein by reference.
3) a resin that contains repeat units that contain a hetero atom, particularly oxygen and/or sulfur (but other than an anhydride, i.e. the unit does not contain a keto ring atom), and preferable are substantially or completely free of any aromatic units. Preferably, the heteroalicyclic unit is fused to the resin backbone, and further preferred is where the resin comprises a fused carbon alicyclic unit such as provided by polymerization of a norborene group and/or an anhydride unit such as provided by polymerization of a maleic anhydride or itaconic anhydride. Such resins are disclosed in PCT/US01/14914 and U.S. application number 09/567,634.
4) a resin that contains fluorine substitution (fluoropolymer), e.g. as may be provided by polymerization of tetrafluoroethylene, a fluorinated aromatic group such as fluoro-styrene compound, and the like. Examples of such resins are disclosed e.g. in PCT/US99/21912.

Suitable photoacid generators to employ in a positive or negative acting photoresist overcoated over a coating composition of the invention include imidosulfonates such as compounds of the following formula: 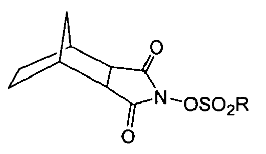 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Sulfonate compounds are also suitable PAGs for resists overcoated a coating composition of the invention , particularly sulfonate salts. Two suitable agents for 193 nm and 248 nm imaging are the following PAGS 1 and 2:

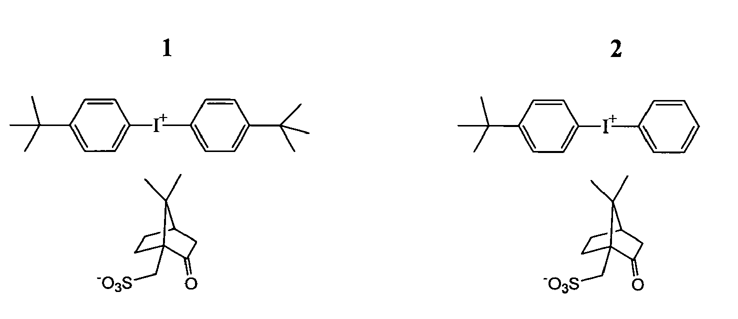

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula RSO₃- where R is adamantane, alkyl (e.g. C₁₋₁₂ alkyl) and perfluoroalkyl such as perfluoro (C₁₋₁₂alkyl), particularly perfluorooctanesulfonate, perfluorobutanesulfonate and the like.

Other known PAGS also may be employed in photoresist used with underlaying coating compositions.

A preferred optional additive of photoresists overcoated a coating composition of the invention is an added base, particularly tetrabutylammonium hydroxide (TBAH), or tetrabutylammonium lactate, which can enhance resolution of a developed resist relief image. For resists imaged at 193 nm, a preferred added base is a hindered amine such as diazabicyclo undecene or diazabicyclononene. The added base is suitably used in relatively small amounts, e.g. about 0.03 to 5 percent by weight relative to the total solids.

Preferred negative-acting resist compositions for use with an overcoated coating composition of the invention comprise a mixture of materials that will cure, crosslink or harden upon exposure to acid, and a photoacid generator.

Particularly preferred negative-acting resist compositions comprise a resin binder such as a phenolic resin, a crosslinker component and a photoactive component of the invention. Such compositions and the use thereof have been disclosed in European Patent Applications 0164248 and 0232972 and in U.S. Pat. No. 5,128,232 to Thackeray et al. Preferred phenolic resins for use as the resin binder component include novolaks and poly(vinylphenol)s such as those discussed above. Preferred crosslinkers include amine-based materials, including melamine, glycolurils, benzoguanamine-based materials and urea-based materials. Melamine-formaldehyde resins are generally most preferred. Such crosslinkers are commercially available, e.g. the melamine resins sold by Cytec Industries under the trade names Cymel 300, 301 and 303. Glycoluril resins are sold by Cytec Industries under trade names Cymel 1170, 1171, 1172, Powderlink 1174, and benzoguanamine resins are sold under the trade names of Cymel 1123 and 1125.

Suitable photoacid generator compounds of resists used with antireflective compositions of the invention include the onium salts, such as those disclosed in U.S. Pat. Nos. 4,442,197, 4,603,10, and 4,624,912, each incorporated herein by reference; and non-ionic organic photoactive compounds such as the halogenated photoactive compounds as in U.S. Pat. No. 5,128,232 to Thackeray et al. and sulfonate photoacid generators including sulfonated esters and sulfonlyoxy ketones. See J. of Photopolymer Science and Technology, 4(3):337-340 (1991), for disclosure of suitable sulfonate PAGS, including benzoin tosylate, t-butylphenyl alpha-(p-toluenesulfonyloxy)-acetate and t-butyl alpha(p-toluenesulfonyloxy)-acetate. Preferred sulfonate PAGs are also disclosed in U.S. Pat. No. 5,344,742 to Sinta et al. The above camphorsulfoanate PAGs 1 and 2 are also preferred photoacid generators for resist compositions used with the antireflective compositions of the invention, particularly chemically-amplified resists of the invention.

Photoresists for use with an antireflective composition of the invention also may contain other materials. For example, other optional additives include actinic and contrast dyes, anti-striation agents, plasticizers, speed enhancers, etc. Such optional additives typically will be present in minor concentration in a photoresist composition except for fillers and dyes which may be present in relatively large concentrations such as, e.g., in amounts of from about 5 to 50 percent by weight of the total weight of a resist's dry components.

Various substituents and materials (including resins, small molecule compounds, acid generators, etc.) as being "optionally substituted" may be suitably substituted at one or more available positions by e.g. halogen (F, Cl, Br, I); nitro; hydroxy; amino; alkyl such as C₁₋₈ alkyl; alkenyl such as C₂₋₈ alkenyl; alkylamino such as C₁₋₈ alkylamino; carbocyclic aryl such as phenyl, naphthyl, anthracenyl, etc; and the like.

### Lithographic processing

In use, a coating composition of the invention is applied as a coating layer to a substrate by any of a variety of methods such as spin coating. The coating composition in general is applied on a substrate with a dried layer thickness of between about 0.02 and 0.5 µm, preferably a dried layer thickness of between about 0.04 and 0.20 µm. The substrate is suitably any substrate used in processes involving photoresists. For example, the substrate can be silicon, silicon dioxide or aluminum-aluminum oxide microelectronic wafers. Gallium arsenide, silicon carbide, ceramic, quartz or copper substrates may also be employed. Substrates for liquid crystal display or other flat panel display applications are also suitably employed, for example glass substrates, indium tin oxide coated substrates and the like. Substrates for optical and optical-electronic devices (e.g. waveguides) also can be employed.

Preferably the applied coating layer is cured before a photoresist composition is applied over the antireflective composition. Cure conditions will vary with the components of the antireflective composition. Particularly the cure temperature will depend on the specific acid or acid (thermal) generator that is employed in the coating composition. Typical cure conditions are from about 80°C to 225°C for about 0.5 to 40 minutes. Cure conditions preferably render the coating composition coating layer substantially insoluble to the photoresist solvent as well as an alkaline aqueous developer solution.

If multiple, distinct antireflective coating compositions are applied to a substrate as disclosed herein, preferably each layer is cured before application of a subsequent layer.

After such curing, a photoresist is applied above the surface of the top coating composition. As with application of the bottom coating composition layer(s), the overcoated photoresist can be applied by any standard means such as by spinning, dipping, meniscus or roller coating. Following application, the photoresist coating layer is typically dried by heating to remove solvent preferably until the resist layer is tack free. Optimally, essentially no intermixing of the bottom composition layer and overcoated photoresist layer should occur.

The resist layer is then imaged with activating radiation through a mask in a conventional manner. The exposure energy is sufficient to effectively activate the photoactive component of the resist system to produce a patterned image in the resist coating layer. Typically, the exposure energy ranges from about 3 to 300 mJ/cm² and depending in part upon the exposure tool and the particular resist and resist processing that is employed. The exposed resist layer may be subjected to a post-exposure bake if desired to create or enhance solubility differences between exposed and unexposed regions of a coating layer. For example, negative acid-hardening photoresists typically require post-exposure heating to induce the acid-promoted crosslinking reaction, and many chemically amplified positive-acting resists require post-exposure heating to induce an acid-promoted deprotection reaction. Typically post-exposure bake conditions include temperatures of about 50°C or greater, more specifically a temperature in the range of from about 50°C to about 160°C.

As discussed, the photoresist layer also may be exposed in an immersion lithography system, i.e. where the space between the exposure tool (particularly the projection lens) and the photoresist coated substrate is occupied by an immersion fluid, such as water or water mixed with one or more additives such as cesium sulfate which can provide a fluid of enhanced refractive index. Preferably the immersion fluid (e.g., water) has been treated to avoid bubbles, e.g. water can be degassed to avoid nanobubbles.

References herein to "immersion exposing" or other similar term indicates that exposure is conducted with such a fluid layer (e.g. water or water with additives) interposed between an exposure tool and the coated photoresist composition layer.

The exposed resist coating layer is then developed, preferably with an aqueous based developer such as an alkali exemplified by tetra butyl ammonium hydroxide, sodium hydroxide, potassium hydroxide, sodium carbonate, sodium bicarbonate, sodium silicate, sodium metasilicate, aqueous ammonia or the like. Alternatively, organic developers can be used. In general, development is in accordance with art recognized procedures. Following development, a final bake of an acid-hardening photoresist is often employed at temperatures of from about 100°C to about 150°C for several minutes to further cure the developed exposed coating layer areas.

The developed substrate may then be selectively processed on those substrate areas bared of photoresist, for example, chemically etching or plating substrate areas bared of photoresist in accordance with procedures well known in the art. Suitable etchants include a hydrofluoric acid etching solution and a plasma gas etch such as an oxygen plasma etch. A plasma gas etch removes the antireflective coating layer.

As indicated above, underlaying coating compositions can be particularly useful in difficult imaging environments, such as coating over dark substrates e.g. a substrate that has a carbon layer or a nitride-based surface. In those environments, the substrate can be too absorbing, thereby preventing effective imaging of bottom portions of a photoresist layer. By use of a present underlayer composition with resin blend that has an intermediate level of absorbance, such resolution-limiting problems of a dark substrate can be avoided.

In immersion lithography systems, angles of incident exposure radiation can be severe. By use of multiple underlying absorbing layers as disclosed herein, which have differing absorbance levels, to thereby provide a graded absorbance environment, reflection problems arising from incident exposure radiation can be effectively addressed.

The following non-limiting examples are illustrative of the invention. All documents mentioned herein are incorporated herein by reference.

### EXAMPLES 1-26: Syntheses of resins

Example 1. A terpolymer consisting of styrene, 2-hydroxyethylmethacrylate and methacrylate monomers with a mole ratio of 30:38:32 was synthesized according to the following procedure:
The monomers (styrene, 99% pure from Aldrich, 169.79g; 2-hydroxyethylmethacrylate obtained from Rohm and Haas Corporation "Rocryl 400", 269.10; and methyl methacrylate obtained from Rohm & Haas Corporation, 173.97 g), were dissolved in 2375 g of THF in a 5L 3-necke round bottom fitted with overhead stirring, a condenser, and a nitrogen inlet. The reaction solution was degassed with a stream of nitrogen for 20 min. The Vazo 52 initiator (11.63 g, from DuPont corporation) was added and the solution heated to reflux. This temperature was maintained for 15 hours. The reaction solution was cooled to ambient temperature and precipitated into 12L of methyl tertiary butyl ether (MTBE)/cyclohexane (v/v 1/1). The polymer was collected by filtration under reduced pressure and dried under vacuum at about 50°C. for 48 hours. The polymer yield was 68% of which about 2.4wt% was residual monomers. This product was found to have a glass transition temperature, Tg, of about 92°C and a molecular weight by gel permeation chromatography relative to polystyrene standards of about Mw = 22416, Mn=10031.
Example 2. A tetrapolymer of styrene:2-hydroxyethylmethacrylate:
methylmethacrylate:n-butyl methacrylate in a mole % ratio of 30:38:31:1 was synthesized according to the procedure of Example 1; with the mole % of the initiator (Vazo 52) at 0.72%. Molecular weight analysis by gel permeation chromatography relative to polystyrene standards gave a weight average molecular weight of about 22646 and a number average molecular weight of about 10307 Daltons.
Example 3. A tetrapolymer of styrene:2-hydroxyethylmethacrylate:
methylmethacrylate:n-butyl methacrylate in a mole % ratio of 55:30:14:1 was synthesized according to the procedure of Example 1; with the mole % of the initiator (Vazo 52) at 0.27%. Molecular weight analysis by gel permeation chromatography relative to polystyrene standards gave a weight average molecular weight of about 124761 and a number average molecular weight of about 36638 Daltons.
Example 4. A terpolymer of styrene:2-hydroxyethylmethacrylate:methylmethacrylate in a mole % ratio of 10:70:20 was synthesized according to the following procedure: To a 1L reactor equipped with nitrogen inlet, water cooled condenser, thermocouple, electric motor with Teflon 2 blades agitator and jacket for heating/cooling were charged 32.4 g of propylene glycol methyl ether (PGME) followed by 42 g of monomer mixture pre-made at described molar ratio. The reaction mixture was stirred at 20 °C and 14.6 g of initiator solution (1.68 g of 2,2-azobis-methylbutyronitrile (ABMBN) in 249 g PGME) added. After the initiator was added, the reaction mixture was heated to 100°C and 98 g of the monomers mixture added over one hour. At the same time the remainder of the initiator solution (131.28 g) was slowly added over four hours. The temperature was maintained at 100°C throughout the additions. At the end of the initiator addition the reaction temperature was held at 100°C for one more hour. The reaction mixture was further diluted with 290 g of PGME and cooled to 25°C. For the purpose of the invention the polymer solution may be used at this or lower concentration as it may be necessary. Isolation of the tetrapolymer was achieved by the slow addition of 120 g of polymer solution into 1.2 L of de-mineralized water. The precipitate was collected on a Buchner funnel and washed with two 150 g portions of de-mineralized water. The product was first air dried followed by vacuum drying at 50°C. Molecular weight analysis of the dried sample by gel permeation chromatography relative to polystyrene standards gave a weight average molecular weight of about 31286 and a number average molecular weight of 5912 Daltons.

Example 5 to 10. Representative copolymers of 2-hydroxyethylmethacrylate (HEMA) and methylmethacrylate (MMA) were prepared according to the procedure of Example 4. The copolymer compositions based on the monomer mole % feed ratio, initiator mole % and the resulting polymer molecular weights are presented in Table 1.

**Table 1**

| Example | Composition HEMA:MMA mole:mole | Initiator mole% | Mw | Mn | PD |
|---|---|---|---|---|---|
| 5 | 40:60 | 3.10% | 29715 | 11354 | 2.62 |
| 6 | 40:60 | 10.00% | 12954 | 4929 | 2.63 |
| 7 | 50:50 | 3.10% | 28777 | 9339 | 3.08 |
| 8 | 60:40 | 10 | 11,528 | 4,123 | 2.8 |
| 9 | 60:40 | 3.10% | 30050 | 14558 | 2.06 |
| 10 | 60:40 | 2.0 | 81,553 | 18,561 | 4.39 |
| 11 | 30:70 | 3.10% | 25936 | 6041 | 4.29 |
| 12 | 80:20 | 3.00% | 23780 | 5529 | 4.3 |

Examples 13 to 15. Copolymers of methyl 2-hydroxymethyl acrylate (HMAAME) with methylmethacrylate (MMA) and ethyl 2-hydroxymethyl acrylate (HMAAEE) with MMA were prepared according to the procedure of Example 4. All copolymers were made with a 50:50 monomer feed. The initiator concentration and the resulting polymer molecular weight are summarized in Table 2.

**Table 2**

| Example | Composition RHMA:MMA mole:mole R=M(methyl) or E(ethyl) | Initiator mole% | Mw | Mn | PD |
|---|---|---|---|---|---|
| 13 | 50M:50 | 3.1% | 18703 | 9507 | 1.97 |
| 14 | 50E:50 | 3.1% | 19791 | 5652 | 3.50 |
| 15 | 50E:50 | 1.2% | 37046 | 6620 | 5.60 |

Example 16. A terpolymer of 9-anthracenemethyl methacrylate(ANTMA):2-hydroxyethylmethacrylate(HEMA):methyl methacrylate(MMA)in a mole % ratio of 43:25:32 was synthesized according to the following procedure:

A 12 L 3-neck round bottom flask equipped with an overhead stirrer, condensed and nitrogen inlet was charged with 537.5 g of 9-anthracenemethyl methacrylate, 312.5 g of 2-hydroxyethyl methacrylate, 400.0 g of methyl methacrylate, and 8.00 L of tetrahydrofuran (THF). The ANTMA was first dissolved in 4 L of THF in the reaction vessel and then the HEMA and MMA were added along with another 4 L of THF. The solution was degassed for 20 minutes with nitrogen through the dispersion tube. The reaction mixture was heated during degassing in order to maintain the temperature at approximately 25°C. After degassing, 5.0 g of AIBN were added. The reaction mixture was heated at reflux for 24 hours. The reaction mixture was cooled to room temperature, precipitated into methyl t-butylether(MBTE), collected and dried under vacuum at 70° C for 96 hours. About 1 Kg (80% yield) of a pale yellow polymer was obtained with a Mw of 64,640, a Mn of 26,258 and a Tg of 138°C.

### General synthesis Procedure for Examples 17 to 26

The following examples demonstrate unique features in regards to monomer combinations, selection of chromophore, amount of chromophore, charge of solvent, charge of acid catalyst, and polymer isolation. All reagents were initially charged into the reactor with little regard to the order of addition. The reaction setup consists of a 100 or 250-mL three-neck, round-bottom flask fitted with a mechanical stirrer, temperature control box, temperature probe, heating mantle, condenser, Dean-Stark trap, and nitrogen purge inlet (sweep). Each reaction was heated first to substantial reflux (120-150 C), and then gradually to a peak temperature of about 150°C within 30 minutes. The total reaction time (Table 3) for each reaction was marked from the point of substantial reflux, to the commencement of thermal quench. The cooled solutions were diluted prior to precipitation. The polymers were collected by filtration through a Buchner funnel, air-dried, and then dried *in vacuo* between 40-70°C. Polymer yields and GPC results are noted in Table 3.

### Example 17

Charge: Dimethylterephthalate (DMT) (46.15g, 237.6 mmol), 1,3,5-tris(2-hydroxyethyl)isocyanurate (THEIC) (62.08g, 237.6 mmol), 4-hydroxyphenylacetic acid (4-HPAA) (8.48g, 55.7 mmol), p-toluenesulfonic acid monohydrate (PTSA) (2.1 g, 11mmol), and anisole (80g). The polymer solution was diluted with isopropyl alcohol (IPA) and tetrahydrofuran (THF), and precipitated into IPA to obtain 81 % of yield.

### Example 18

Charge: Dimethylterephthalate (DMT) (36.19g, 186.4 mmol), 1,3,5-tris(2-hydroxyethyl)isocyanurate (THEIC) (48.69g, 186.4 mmol),), 4-hydroxyphenylacetic acid (4-HPAA) (30.54g, 200.7 mmol), p-toluenesulfonic acid monohydrate (PTSA) (2.1g, 11mmol), and anisole (80g). The polymer solution was diluted with isopropylalcohol (IPA) and tetrahydrofuran (THF), and precipitated into IPA.

### Example 19

Charge: DMT (22.3g, 115 mmol), dimethyl 5-hydroxyisophthalate (18.1g, 86 mmol), THEIC (52.5g, 201 mmol), 2-hydroxyisobutyric acid (17.9g, 172 mmol), PTSA (2.1g, 11 mmol), and anisole (80g). The polymer solution was diluted with THF (355g) and precipitated into IPA.

### Example 20

Charge: DMT (22.3g, 115 mmol), dimethyl 5-hydroxyisophthalate (18.1g, 86 mmol), THEIC (52.5g, 201 mmol), 2-hydroxyisobutyric acid (18.0g, 172 mmol), PTSA (2.1g, 11 mmol), and anisole (82g). The polymer solution was diluted with THF (355g) and precipitated into IPA.

### Example 21

Charge: DMT (39.0g, 201 mmol), THEIC (52.5g, 201 mmol), 2-hydroxyisobutyric acid (18.0g, 172 mmol), PTSA (2.7g, 14 mmol), and anisole (83g). The polymer solution was diluted with THF (358g) and precipitated into IPA.

### Example 22

Charge: Dimethyl terephthalate (48.5g, 250 mmol), ethylene glycol (12.4g, 200 mmol), glycerol (9.0g, 100 mmol), and PTSA (0.54g, 2.8 mmol). Enough propylene glycol methyl ether acetate (PMA) was added to prepare an 8% solution.

### Example 23

Charge: Dimethyl 2,6-naphthalenedicarboxylate (24.33g, 99.63 mmol), dimethylterephthalate (19.44g, 100.1 mmol), ethylene glycol (7.63g, 123 mmol), glycerol (7.29g, 79.2 mmol), and PTSA (0.46g, 2.4 mmol). The resultant polymer was dissolved in a solvent mixture of HBM, anisole, and methyl 2-methoxyisobutyrate (MBM) to prepare a 10% solution.

### Example 24

Charge: Dimethyl terephthalate (31.15g, 160.4 mmol), 1,3,5-tris (2-hydroxyethyl)cyanuric acid (46.09g, 176.4 mmol), and PTSA (1.35g, 7.1 mmol) and anisole (52 g) The resultant polymer was diluted to 25% solution with HBM and precipitated into IPA to obtain 45.3 g (67%) of resin.

### Example 25

Charge: Dimethyl terephthalate (31.11g, 160.2 mmol), 1,3,5-tris (2-hydroxyethyl)cyanuric acid (45.80g, 175.3 mmol), and PTSA (0.67g, 3.5 mmol). The resultant polymer was dissolved in THF and precipitated in MTBE to obtain 50.0g (75%).

### Example 26

Charge: dimethyl phthalate (30.91g, 159.2 mmol), 1,3,5-tris (2-hydroxyethyl)cyanuric acid (46.06g, 176.3 mmol), and PTSA (0.67g, 3.5 mmol). The resultant polymer was dissolved in THF and precipitated in MTBE to obtain 51.1g (76%).

**Table 3. Reaction Time and Material Results for Synthetic Examples.**

| Example | Rxn Time (h) | Yield (%) | Mw (RI) | Mn (RI) | PDI |
|---|---|---|---|---|---|
| 17 | 5.5 | 81 | 3376 | 2061 | 1.63 |
| 18 | 5.5 | 48 | 2643 | 1908 | 1.38 |
| 19 | 5.25 | 28 | 2840 | 2064 | 1.37 |
| 20 | 6 | 30 | 2620 | 2041 | 1.28 |
| 21 | 7 | 55 | 2495 | 1754 | 1.42 |
| 22 | 15 | Sol | 5205 | 1909 | 2.73 |
| 23 | 4 | Sol | 4065 | 1782 | 2.28 |
| 25 | 7 | 45 | 4355 | 2201 | 1.97 |
| 25 | 2 | 50 | 3562 | 2056 | 1.73 |
| 26 | 8 | 51 | 2849 | 1772 | 1.61 |

### EXAMPLES 27-38: Lithographic processing and results

### General Procedures for Formulation Examples

Polymers in the examples above were further characterized for their optical density (OD). Representative polymer examples were then formulated into anti-reflective compositions of the invention. These compositions were characterized for optical density (OD), n and k optical parameters, oxide etch-rate, and solubility in propylene glycol methyl ether (PGME) or propylene glycol methyl ether acetate (PGMEA). Each composition was prepared by charging the indicated components into a clean bottle without regard to order of addition. The samples were shaken or placed on rollers until completely dissolved. Each sample was then passed through a 0.2 µm PTFE membrane filter into a clean bottle.

### General Procedure for OD Determination

OD measurements were obtained by coating the formulated samples onto 4 inch silicon and quartz wafers using a table-top spin coater for 30s. Spin-speeds varied as necessary to obtain film thickness in the range of 40-120nm. The coated wafers were cured on a contact hotplate at 215C for 60s. Film thickness (on silicon wafers) was measured by ellipsometry. The absorptivity of the films on quartz was determined by UV spectrophotometry. The absorptivity was measured against a blank quartz wafer. OD was calculated at 193nm using thickness and absorptivity measurements (Table 4).

### General Procedure for Measuring Etch-Rate

Anti-reflectant coatings for etch rate testing were obtained on 200mm silicon wafers using an ACT8 coating tool. Spin-speeds varied as necessary to obtain film thickness greater than 100nm. Cure conditions were 215C/60s on a proximity hotplate. Film thickness was measured by ellipsometry. The films were then subject to blanket oxide etch (C₄F₈/O₂/CO/Ar) for 30s. The thickness of the etched films was re-measured and an etch rate calculated (Table 4).

### General Procedure for Measuring Optical Parameters

Anti-reflectant coatings were obtained on 200mm silicon wafers using an ACT8 coating tool. Spin-speeds varied as necessary to obtain film thickness in the range of 40-120nm. Cure conditions were 215°C for 60 seconds on a proximity hotplate. Film thickness was determined by ellipsometry. A WVASE32 ellipsometer (available from Woollman Company) was used to determine the real (n) and imaginary (k) refractive indices (Table 4).

### General Procedure for Lithographic Evaluation

The antireflective coatings of Examples 30 and 33 were spin coated on 200 mm silicon wafers using an ACT8 wafer coating tool, and then cured using a proximity hotplate at 215°C/60s. Spin speeds were varied as necessary so that the antireflective film thickness after cure was 40-120nm. Next, a positive-acting 193nm photoresist was spin coated on top of the antireflective film, and cured at 120°C/90 seconds to give a 330nm thick film of photoresist. The photoresist was then exposed through a target mask using a 193nm ArF wafer scanner with a 0.75 numerical aperature and annular illumination with 0.85/0.55 inner/outer partial coherence. The exposed resist film was given a 120°C/60 sec post-exposure bake and then developed using Rohm and Haas MF26A developer (2.38% tetramethyl ammonium hydroxide in water) in a standard 60 second single-puddle process.

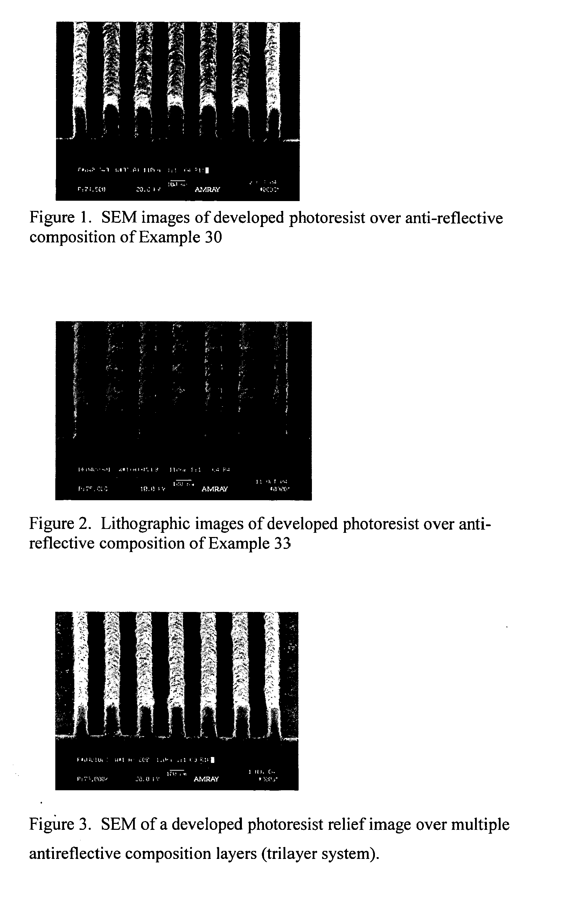

The quality of the resist patterns was examined by scanning electron microscopy (SEM) at 75,000 magnification. The SEM images showed good pattern fidelity with a clean interface between the resist and the antireflective layer. The resist pattern was free of "standing wave" artifacts caused by reflective interference phenomena. SEM images of a 110nm 1:1 line:space resist pattern over the antireflective coating of Examples 30 and 33 are shown in Figure 1 and Figure 2.

When high numerical aperture lenses are used typical of 193 nm immersion lithography a graded anti-reflective coating is required. This may be achieved with a tri-layer process. In such a process a thin, high light absorbing anti-reflective layer is deposited on the substrate and thermally cross-linked. A second, lower light absorbing anti-reflective layer is deposited on the first layer and also cross-linked. The thickness of these layers is typically in the range of 30 to 80 nm. For these layers to be effective they need to have approximately the same refractive indices of about 1.7 to 1.8 but the bottom layer needs to have a higher optical density. Generally k is about 0.4 to 0.6 for the bottom layer and about 0.15 to 0.25 for the upper layer. On top of the anti-reflective layers is then coated the Photoresist to form a 200 to 300 nm film. The tri-layer process is demonstrated in Figure 3 where composition of Example 28 is used to form the first layer of about 58 nm thick, composition of Example 33 is the second layer of about 80 nm thick with a chemically-amplified positive photoresis (about 260 nm thick) forming the top layer.

### Example 27.

Polymer of Example 19 was formulated into an anti-reflective composition by mixing together 3.28 wt% polymer, 0.600 wt% tetramethoxyglycouril, 0.0424 wt% ammonium p-toluenesulfonate, 0.080 wt% triphenylsulfonium perfluorobutanesulfonate, and 96 wt% methyl-2-hydroxyisobutyrate.

Examples 28 to 36 were prepared according to the procedure of Example 27 by mixing polymer of Example 19 with polymer of Example 4 and polymer of Example 19 with various HEMA:MMA copolymers prepared according to Example 5 to 12. The polymers, polymer blend ratio, optical properties and oxide etch of the blends are summarized in Table 4.

**Table 4. 193nm Optical properties and oxide etch characteristics of anti-reflective examples.**

| Example No. | Polymer from Example | % Polymer from Example in Blend | OD @ 193nm | n @ 193nm | k @ 193nm | Oxide etch rate (A/sec) |
|---|---|---|---|---|---|---|
| 28 | 19 | 100 | 11.6 | 1.79 | 0.4 | 20.1 |
| 29 | 4 | 100 | | | 0.16 | |
| 30 | 4 | 75 | 6.3 | | 0.23 | 17 |
| 31 | 4 | 50 | | | 0.3 | |
| 32 | 8 | 25 | 9.2 | | 0.325 | |
| 33 | 8 | 50 | 6.31 | | 0.22 | 19 |
| 34 | 8 | 75 | 3.72 | | 0.13 | |
| 35 | 10 | 75 | 3.64 | | 0.13 | 19 |
| 36 | 12 | 50 | 5.89 | | 0.21 | 18.6 |

The foregoing description of this invention is merely illustrative thereof, and it is understood that variations and modifications can be made without departing from the spirit or scope of the invention as set forth in the following claims.

## Claims

1. A coated substrate comprising:
an antireflective composition layer comprising a resin mixture, resins, wherein at least one resin of the mixture comprises chromophore groups and at least one resin of the mixture is at least substantially or completely free of chromophore groups; and
a photoresist layer over the antireflective composition layer.

2. The substrate of claim 1 wherein the antireflective composition comprises one or more polyester resins and/or more acrylate resins.

3. A method of forming a photoresist relief image, comprising:
applying an antireflective composition layer on a substrate, the antireflective composition comprising a resin mixture, wherein at least one resin of the mixture comprises chromophore groups and at least one resin of the mixture is at least substantially or completely free of chromophore groups; and
applying a photoresist composition layer over the antireflective composition layer; and
exposing and developing the photoresist layer to provide a resist relief image.

4. An antireflective composition for use with an overcoated photoresist composition, the antireflective composition comprising at least one resin of the mixture comprises chromophore groups and at least one resin of the mixture is at least substantially or completely free of chromophore groups

5. The antireflective composition of claim 4 wherein the antireflective composition comprises one or more polyester resins and/or more acrylate resins.

6. A coated substrate comprising:
i) a first organic antireflective composition layer;
ii) a second organic antireflective composition layer above the first antireflective composition layer and having a different absorbance of exposure radiation than the first antireflective composition layer; and
iii) a photoresist layer over the second antireflective composition layer.

7. The substrate of claim 6 wherein the first and second antireflective compositions do not contain a Si resin.

8. A method of forming a photoresist relief image, comprising:
applying a first organic antireflective composition layer on a substrate;
applying a second organic antireflective composition layer above the first organic antireflective composition layer, the second organic antireflective composition layer having a different absorbance of exposure radiation than the first antireflective composition layer; and
applying a photoresist composition layer above the second antireflective composition layer..

9. The method of claim 8 wherein the first and second antireflective compositions each comprises one or more polyester resins and/or more acrylate resins.

10. The method of claim 8 wherein the first antireflective composition layer has an absorbance k value at 193 nm of about 0.3 or greater and the second antireflective composition layer has an absorbance k value at 193 nm of about 0.3 or less.
